# EUROPEAN PATENT SPECIFICATION

(11) **EP 4 614 171 B1**
(45) Date of publication and mention of the grant of the patent: **04.11.2026**
(21) Application number: 24179074.0
(22) Date of filing: 30.05.2024
(51) Int. Cl.: G01R 31/396, H01M 10/48, G01R 31/367

(54) **BATTERY SOC EVALUATION METHOD, APPARATUS, DEVICE AND MEDIUM**
VERFAHREN, VORRICHTUNG, VORRICHTUNG UND MEDIUM ZUR BEURTEILUNG DES LADEZUSTANDS EINER BATTERIE
PROCÉDÉ, APPAREIL, DISPOSITIF ET SUPPORT D'ÉVALUATION D'ÉTAT DE CHARGE DE BATTERIE

(30) Priority: 04.03.2024 CN 202410245133
(43) Date of publication of application: 10.09.2025
(73) Proprietor: Beijing Hyperstrong Technology Co., Ltd., Beijing 100094 (CN)
(72) Inventor: MA, Hao, Beijing, 100094 (CN); HE, Zhichao, Beijing, 100094 (CN); YANG, Guang, 100094, Beijing (CN)
(74) Representative: Santarelli

(56) References cited:
- CN-A- 112 034 369
- CN-A- 112 363 075
- CN-A- 112 816 880
- US-A1- 2023 236 261
- US-A1- 20240 361 388

## Description

### TECHNICAL FIELD

The present application relates to the field of battery technology and, in particular, to a battery SOC evaluation method, an apparatus, a device and a medium.

### BACKGROUND

Battery state of charge (SOC), as a quantitative evaluation of a state of charge stored within a battery, is used to characterize the ability of an energy storage system to store/release remaining power, and to prevent over-charge and over-discharge of the battery and ensure the safety of the energy storage system. However, the battery SOC cannot be measured directly, but can only be obtained by external characteristic parameters such as a voltage of the battery.

Existing methods for battery SOC estimation incorporate many algorithms, including a data-driven method, a Kalman filtering method, etc. However, these algorithms are used to perform overall evaluation on a battery system, and do not evaluate each battery cell of the battery system, which leads to inaccurate evaluation results.

Therefore, the present application proposes an evaluation method that can improve the accuracy of SOC evaluation.

US 2023/236261 A1 discloses a method for acquiring a battery capacity, includes: acquiring multiple initial charging parameters of a battery when the battery is charged during a current charging process, where state of charge (SOC) of the battery in the current charging process changes for a range covering an SOC range, or a minimum charging temperature of the battery in the current charging process is greater than or equal to a temperature threshold; periodically acquiring multiple actual charging parameters of the battery during the current charging process and a current number of charging times corresponding to the current charging process; and acquiring, according to the multiple initial charging parameters, the multiple actual charging parameters, and the current number of charging times, a predicted battery capacity of the battery in a next charging process.

### SUMMARY

The present application provides a battery SOC evaluation method, an apparatus, a device and a medium, which are used for solving problems of lacking analysis on a battery cell of a battery system and a result of battery SOC evaluation being not accurate enough in the prior art. The present application is set out in the appended set of claims.

### BRIEF DESCRIPTION OF DRAWINGS

In order to illustrate technical solutions in embodiments of the present application or in the related art more clearly, the drawings needed to be used in the description of embodiments or the prior art will be briefly introduced below. Obviously, the drawings in the following description are some embodiments of the present application, and other drawings can be obtained by those of ordinary skills in the art according to these drawings without paying creative effort.
FIG. 1 is a schematic diagram of a scenario of battery SOC evaluation provided by an embodiment of the present application.
FIG. 2 is schematic flowchart 1 of a battery SOC evaluation method provided by an embodiment of the present application.
FIG. 3 is schematic flowchart 2 of a battery SOC evaluation method provided by an embodiment of the present application.
FIG. 4 is schematic flowchart 3 of a battery SOC evaluation method provided by an embodiment of the present application.
FIG. 5 is schematic flowchart 4 of a battery SOC evaluation method provided by an embodiment of the present application.
FIG. 6 is a diagram of a battery SOC evaluation apparatus provided by an embodiment of the present application.
FIG. 7 is a schematic diagram of hardware of a battery SOC evaluation device provided by an embodiment of the present application.

### DESCRIPTION OF EMBODIMENTS

In order to make purposes, technical solutions and advantages of embodiments of the present application clearer, the solutions of the embodiments of the present application will be described clearly and completely in connection with the drawings in the embodiments of the present application in the following. Obviously, the described embodiments are some embodiments of the present application, but not all embodiments. Based on the embodiments of the present application, all other embodiments obtained by those of ordinary skills in the art without paying creative effort belong to the protection scope of the present application.

Driven by the goal of "double carbon", energy storage industry, as a supporting industry and a key promoter of energy structure adjustment, has wide application prospects in many fields such as traditional power generation, power transmission and distribution, power demand side, auxiliary services and new energy, etc. As a kind of electrochemical energy storage device, lithium-ion batteries (lithium batteries for short) are widely used in electrochemical energy storage and other fields. A electrochemical energy storage power station is mainly formed by a lithium battery pack, an energy storage converter (Power Conversion System, PCS), an isolation transformer, a battery management system, an energy management system and so on, to realize overall charging-discharging control of the system. Among them, a core of the electrochemical energy storage power station is the battery, and the safety of the battery directly affects the safety of the energy storage system.

Battery state of charge (SOC), as a quantitative evaluation of a state of charge stored in a battery, is used to characterize the ability of an energy storage system to store/release remaining power, and to prevent over-charge and over-discharge of the battery and ensure the safety of the energy storage system. However, a battery management system (BMS) cannot obtain the SOC by direct measurement, but can only perform comprehensive analysis and estimation on battery external characteristic parameters, such as a battery terminal voltage, etc. The accurate SOC evaluation ability can not only improve the safety of a battery pack, but also improve the overall performance and service life of the battery pack.

However, currently, methods for battery SOC estimation used in the BMS not only have low accuracy and are too complicated, but also mostly evaluate an overall SOC of the system, without accurately evaluating an SOC of each cell (battery cell), which will greatly reduce the scope and accuracy of the evaluation.

Therefore, the present application proposes an evaluation method based on the measurement on a battery cell, which can improve the accuracy of SOC evaluation.

Next, an implementation process of a battery SOC evaluation method proposed by the present application is explained in combination with the drawings and specific embodiments.

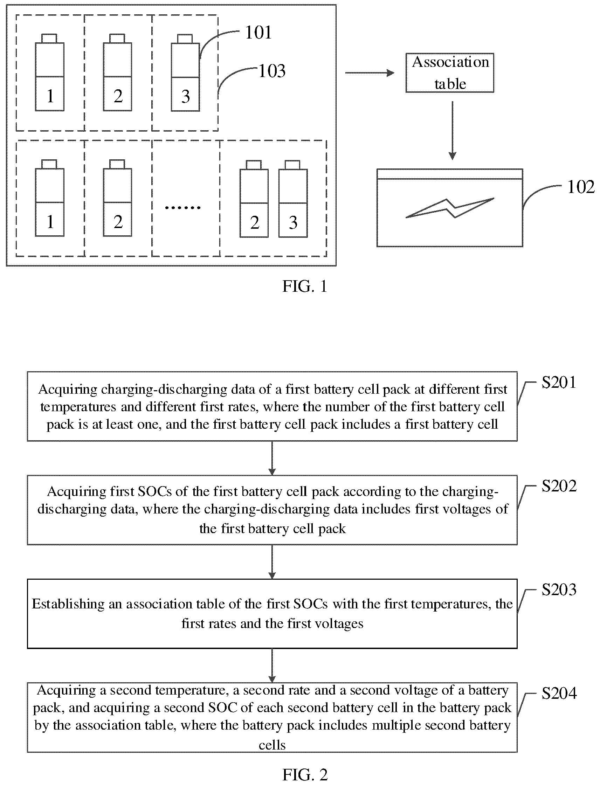

FIG. 1 is a schematic diagram of a scenario of battery SOC evaluation provided by an embodiment of the present application. As shown in FIG. 1, the system includes: first battery cells 101 and a battery pack 102. The battery pack 102 includes multiple second battery cells, and each of the first battery cells 101 and the second battery cells is a battery cell.

The battery pack 102 is formed by multiple second battery cells, and battery cells in the battery pack 102 may be connected in series. The first battery cells 101 may be sampling batteries, and data related thereto is used to establish an association table. The association table is used to express a relationship between battery external characteristic parameters and battery SOCs. The association table can be used to estimate an SOC of each second battery cell in the actual battery pack 102, which can identify the SOC of each battery cell of the battery pack simply and accurately.

Acquisition of external characteristic parameters of the first battery cells 101 includes acquiring charging-discharging data of a first battery cell pack 103 at different first temperatures and different first rates. The first battery cell pack is in units of first battery cells, and the first battery cells may be measured separately and may also be measured in combination. For example, when measuring three battery cells to establish the association table, battery cell a, battery cell b and battery cell c in the first battery cells 101 are measured separately. Or, battery cell d, battery cell e and battery cell f in the first battery cells 101 can be measured separately, and some battery cells can be selected and combined together for measurement, where battery e and battery f are selected and can be connected in series together for measurement.

First SOCs of the first battery cell pack 103 can be acquired according to the charging-discharging data of the first battery cell pack 103, and an association table of the first SOCs with the first temperatures, the first rates and the first voltages is established. The association table can be used for the battery pack 102. Measurement is performed on the battery pack 102 in real time to obtain a second temperature, a second rate and a second voltage of the battery pack 102, and by looking up the association table, a second SOC of each second battery cell in the battery pack 102 can be obtained by contrasting for the battery pack 102.

FIG. 2 is schematic flowchart 1 of a battery SOC evaluation method provided by an embodiment of the present application. As shown in FIG. 2, the method includes the following steps.

S201, acquiring charging-discharging data of a first battery cell pack at different first temperatures and different first rates, where the number of the first battery cell pack is at least one, and the first battery cell pack includes a first battery cell.

The first battery cell pack is placed in a certain measuring space. The measuring space is controlled to reach different first temperatures, and the measuring space is controlled to reach different first rates. The charging-discharging data of the first battery cell pack is acquired at different first temperatures and different first rates. The charging-discharging data is data related to battery charging and battery discharging, including a charging current, a discharging current, etc. There may be multiple first battery cell packs placed in the measuring space, and each first battery cell pack is formed by the first battery cell. Each first battery cell pack may have only one first battery cell and may also have one or more first battery cells. Specifically, a combination mode can be selected for each first battery cell pack according to actual requirements.

S202, acquiring first SOCs of the first battery cell pack according to the charging-discharging data, where the charging-discharging data includes first voltages of the first battery cell pack.

The charging-discharging data of the first battery cell pack includes first voltages and first currents of the first battery cell pack. The first voltages can be used as collectable corresponding data of the association table, and the first currents can be used to calculate the first SOCs of the first battery cell pack. Optionally, a way of calculating a first SOC is an ampere-hour integration method. A first current is a charging-discharging current of the first battery cell pack, and the first SOC of the first battery cell pack can be calculated by a formula of the ampere-hour integration method according to the first current and charging-discharging time of the first battery cell pack as well as the rated capacity of the first battery cell pack.

S203, establishing an association table of the first SOCs with the first temperatures, the first rates and the first voltages.

For each first battery cell pack, the charging-discharging data of the first battery cell pack at the same first temperature can be used to obtain one first SOC. The charging-discharging data includes the first voltage at the same first temperature, and the first rate is data obtained according to the first current and the rated capacity of the first battery cell pack. Then there is one first SOC, one first voltage and one first rate corresponding to the same one first temperature. The first SOC forms a correspondence with the first temperature, the first rate and the first voltage, and an association table can be established. Each first battery cell pack can correspond to one association table.

S204, acquiring a second temperature, a second rate and a second voltage of a battery pack, and acquiring a second SOC of each second battery cell in the battery pack by the association table, where the battery pack includes multiple second battery cells.

The association table includes a correspondence between the first SOCs and the first temperatures, the first rates and the first voltages, and each second battery cell of the battery pack is of the same type as the first battery cell pack, so the battery pack can use the association table. The temperature, the rate and the voltage are all measurable data, and the SOC is unmeasurable data. Temperature, rate and voltage measurement is performed on the battery pack to obtain the second temperature, the second rate and the second voltage. The second temperature, the second rate and the second voltage are mapped to the association table to find the corresponding SOC of the battery pack, and the second SOC of each second battery cell can be found.

In the embodiment of the present application, the association table is constructed through the first battery cell pack, and the second SOC of each second battery cell in the battery pack is evaluated through measurable data of the battery pack in the association table, which ensures that the second SOC of the battery pack is estimate accurately. When establishing the association table, the first battery cell pack is taken as an experimental object. The charging-discharging data of the first battery cell pack is acquired at different first temperatures and different first rates; the first SOCs of the first battery cell pack are acquired according to the charging-discharging data; and the measurable data, such as the first temperatures, the first rates and the first voltages, is associated with the first SOCs to establish the association table. The second temperature, the second rate and the second voltage of the battery pack are acquired, and an association relationship is looked up in the association table, which can acquire the second SOC of each second battery cell in the battery pack accurately and conveniently.

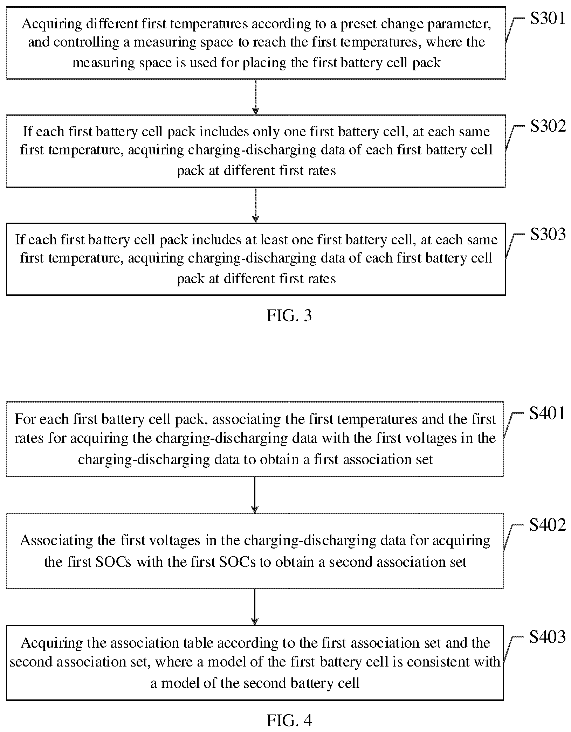

FIG. 3 is schematic flowchart 2 of a battery SOC evaluation method provided by an embodiment of the present application. As shown in FIG. 3, the method includes the following steps.

S301, acquiring different first temperatures according to a preset change parameter, and controlling a measuring space to reach the first temperatures, where the measuring space is used for placing the first battery cell.

The measuring space is used for placing the first battery cell pack. The charging-discharging data of the first battery cell pack need to be measured at different first temperatures, so the measuring space needs to be controlled according to a preset condition to complete temperature control. According to the preset change parameter, the measuring space can be controlled to reach different first temperatures. The change of the first temperatures may be a change in a certain gradient.

The preset change parameter is set as a certain gradient value, and according to the gradient value, the first temperature of the measuring space is adjusted on the basis of an appropriate temperature. For example, 25 degrees Celsius is an appropriate temperature, and a gradient value of the first temperature is set as 10 degrees Celsius, so the temperature setting of the first temperature may be 15 degrees Celsius, 25 degrees Celsius, 35 degrees Celsius, 45 degrees Celsius.

In order to ensure the environment for measuring the measuring space of the first battery cell pack meets the standard, the measuring space can be pre-processed.

Exemplary, before controlling the measuring space to reach the first temperatures, the method further includes:
acquiring a start time node where a humidity of the measuring space does not exceed a preset humidity;
acquiring a standing time length of the measuring space according to the start time node and a current time node, where the standing time length is a time length when the humidity of the measuring space does not exceed the preset humidity continuously;
if the standing time length exceeds a preset time length, confirming to place the first battery cell pack in the measuring space.

The humidity of the measuring space will affect the measurement of the first battery cell pack, so the measuring space should be standing in a stable and dry environment for a period of time. When the humidity of the measuring space does not exceed the preset humidity, then it is considered as being dry. The preset humidity may be set to 60%RH. When the humidity of the measuring space does not exceed 60%RH, then the environment of the measuring space is considered as being dry. The standing time length of the measuring space in the dry environment should exceed the preset time length, and if yes, it is confirmed to place the first battery cell pack in the measuring space. The standing time length may be set to 24 hours or longer time.

The measuring space has a corresponding start time node of reaching dryness and a current time node of keeping dry. The standing time length of the measuring space can be confirmed according to the start time node of being dry and the current time node of keeping dry for the measuring space.

S302, if each first battery cell pack includes only one first battery cell, at each same first temperature, acquiring charging-discharging data of each first battery cell pack at different first rates.

There may be multiple first battery cell packs, and each first battery cell pack may have one first battery cell. That is, only charging-discharging data of the battery cell is collected to establish an association table. Accordingly, at the same first temperature, the charging-discharging data of the first battery cell pack at different first rates is acquired, that is, at the same first temperature, charging-discharging data of each individual first battery cell at different first rates is acquired.

S303, if each first battery cell pack includes at least one first battery cell, at each same first temperature, acquiring charging-discharging data of each first battery cell pack at different first rates.

Each first battery cell pack may also have multiple first battery cells. Multiple first battery cells are selected according to requirements, and the first battery cells are combined. The first battery cell pack obtained after the combination may include one first battery cell and may also include multiple first battery cells. That is, charging-discharging data of the battery cell and charging-discharging data of some combined batteries can be collected to establish an association table. Accordingly, at the same first temperature, charging-discharging data of the first battery cell pack at different first rates is acquired, that is, at the same first temperature, charging-discharging data of the individual first battery cells and the combined first battery cells at different first rates are acquired.

The charging-discharging data of the first battery cell pack is acquired.

Exemplary, if each first battery cell pack includes only one first battery cell, the method further includes:
at each same first temperature, acquiring a first charging-discharging parameter of each first battery cell at the same first rate;
acquiring the charging-discharging data of the first battery cell pack according to a first average value of the first charging-discharging parameter of at least one first battery cell at the same first rate and the first charging-discharging parameter;
if each first battery cell pack includes at least one first battery cell, the method further includes:
   at each same first temperature, acquiring a second charging-discharging parameter of each first battery cell pack at the same first rate;
   acquiring the charging-discharging data of the first battery cell pack according to a second average value of the second charging-discharging parameter of at least one first battery cell pack at the same first rate and the second charging-discharging parameter.

No matter whether each first battery cell pack includes only one first battery cell or each first battery cell pack includes at least one first battery cell, the charging-discharging parameter of each corresponding first battery cell pack can be collected, and the charging-discharging parameter is the measured charging-discharging current and/or other data. If each first battery cell pack includes only one first battery cell, the first charging-discharging parameter is obtained; if each first battery cell pack includes at least one first battery cell, the second charging-discharging parameter is obtained. The first charging-discharging parameter and the second charging-discharging parameter may be directly selected as the charging-discharging data of the first battery cell pack, and may also be selected as the charging-discharging data of the first battery cell pack after taking an average value thereof.

In the embodiment of the present application, the charging-discharging data is measured for the battery cell, so as to facilitate the establishment of the association table that is related to the battery cell and used for SOC estimation and to facilitate the SOC evaluation of the battery pack.

FIG. 4 is schematic flowchart 3 of a battery SOC evaluation method provided by an embodiment of the present application. As shown in FIG. 4, the method includes the following steps.

S401, for each first battery cell pack, associating the first temperatures and the first rates for acquiring the charging-discharging data with the first voltages in the charging-discharging data to obtain a first association set.

The association table of the first SOCs with the first temperatures, the first rates and the first voltages may be not a function expression. The association table may be only used to associate corresponding input values and output values, where the input values include a temperature, a rate and a voltage, and the output value includes an SOC. When the input values are obtained by measurement, the corresponding output value can be obtained by looking up the association table, that is, the SOC of the battery is evaluated. For each first battery cell pack, there is an association between a certain first temperature, a certain first rate and a first voltage in the charging-discharging data obtained by measurement at the certain first temperature and the certain first rate, which is the first association set.

S402, associating the first voltages in the charging-discharging data for acquiring the first SOCs with the first SOCs to obtain a second association set.

For each first battery cell pack, its charging-discharging data measured at a certain first temperature and a certain first rate further includes a first current. The first current can be used to calculate a first SOC, and the calculated first SOC is associated with a first voltage in the charging-discharging data measured at the certain first temperature and the certain first rate as the second association set.

S403, acquiring the association table according to the first association set and the second association set, where a model of the first battery cell is consistent with a model of the second battery cell.

For each first battery cell pack, the first voltage in the charging-discharging data at the same first temperature and the same first rate are associated with the first SOC to obtain the association table.

The first association set and the second association set are combined to obtain the association table of the first SOCs with the first temperatures, the first rates and the first voltages, that is, to obtain an association table of temperatures, rates and voltages and SOCs. When the model of the first battery cell is consistent with the model of the second battery cell, the association table can be used for the battery pack measurement corresponding to the second battery cells.

The battery pack may be in a form of series connection or parallel connection. In order to evaluate the second SOC of the second battery cell therein, the same one negative electrode can be set for each second battery cell, and the second temperature, the second rate and the second voltage of each second battery cell can be obtained based on charging-discharging data of this negative electrode and a positive electrode of each second battery cell, so as to obtain the SOC of each second battery cell with reference to the association table.

In the embodiment of the present application, the SOC of each second battery cell in a charging and discharging process can be accurately evaluated, and SOC differences between different second battery cells within the battery pack can be identified, results of which can be applied to a strategy of recharging and balancing of abnormal batteries, improving the system consistency.

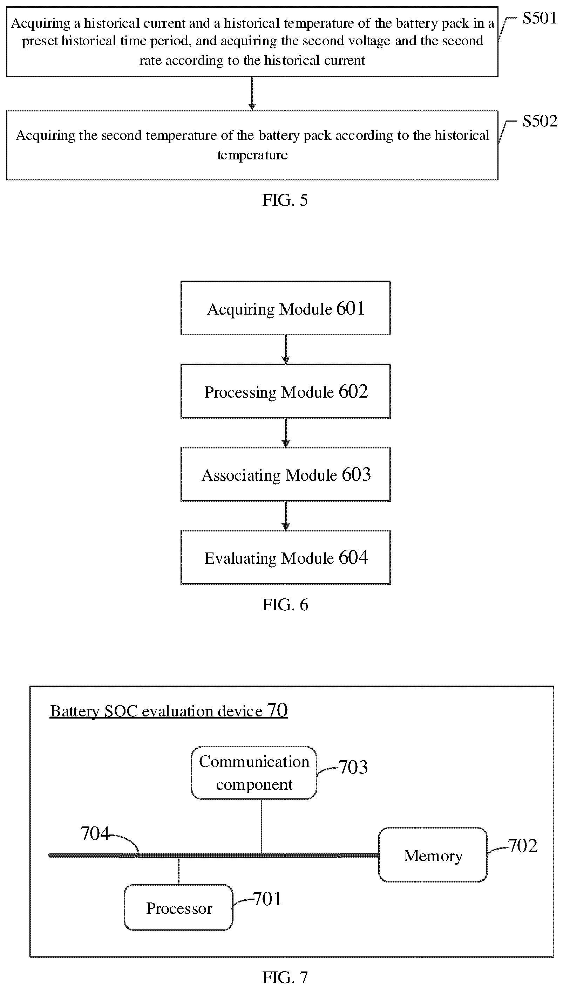

FIG. 5 is schematic flowchart 4 of a battery SOC evaluation method provided by an embodiment of the present application. As shown in FIG. 5, the method includes the following steps.

S501, acquiring a historical current and a historical temperature of the battery pack in a preset historical time period, and acquiring the second voltage and the second rate according to the historical current.

The battery pack has a corresponding temperature value in an actual use environment. The historical temperature can be collected in the preset historical time period, and the historical temperature can be obtained by performing collection once within the preset historical time period or by performing collection more than once to take an average value. The historical current of the battery pack also needs to be acquired in the preset historical time period, and the historical current may be continuously acquired. The second voltage and the second rate can be calculated according to the historical current, the historical temperature and a corresponding formula, and the second rate can be obtained according to a second current and the rated capacity of the second battery cell.

The second voltage can be calculated as follows, exemplarily:
acquiring a current variation according to the preset historical time period and the historical current;
acquiring a first coefficient according to the current variation and a first characteristic parameter of the battery pack;
acquiring a second coefficient according to the preset historical time period, the first characteristic parameter and a second characteristic parameter of the battery pack;
acquiring the second voltage according to the first coefficient and the second coefficient.

A first value of the first coefficient is acquired according to the current variation and a first parameter of the first characteristic parameter of the battery pack; a second value of the first coefficient is acquired according to the current variation and a second parameter of the first characteristic parameter of the battery pack.

A third value of the second coefficient is acquired according to the preset historical time period, the first parameter of the first characteristic parameter and a third parameter of the second characteristic parameter; a fourth value of the second coefficient is acquired according to the preset historical time period, the second parameter of the first characteristic parameter and a fourth parameter of the second characteristic parameter.

The second voltage is acquired according to the first value and the second value of the first coefficient as well as the third value and the fourth value of the second coefficient: $V = - dI ∗ Rd ∗ exp \left(\frac{- dt}{Rd ∗ Cd}\right) - dI ∗ Rd 2 ∗ exp \left(\frac{- dt}{Rd 2 ∗ Cd 2}\right)$ where *V* is a voltage compensation value, and the second voltage can be obtained by the voltage compensation value plus a voltage value in a current state; *dI* is the current variation, *dt* is the preset historical time period; exp(·) is a function with natural numbers as base numbers; *Rd, Cd, Rd*2 and *Cd2* are different battery cell characteristic parameters respectively, namely, the first parameter of the first characteristic parameter, the third parameter of the second characteristic parameter, the second parameter of the first characteristic parameter and the fourth parameter of the second characteristic parameter; and * is a multiplication sign.

S502, acquiring the second temperature of the battery pack according to the historical temperature.

The historical temperature may be obtained by performing collection once within the preset historical time period or by performing collection more than once to take an average value, and can be directly used as the second temperature.

In the present application, battery cell impedance characteristics can also be taken into account, and then evaluation results can more accurately reflect an actual available power of the battery pack. At the same time, based on the evaluated SOC results and combining related control strategies, the safety performance and the service life of the lithium battery can be further improved.

FIG. 6 is a diagram of a battery SOC evaluation apparatus provided by an embodiment of the present application. As shown in FIG. 6, the apparatus includes: an acquiring module 601, a processing module 602, an associating module 603 and an evaluating module 604.

The acquiring module 601 is configured to acquire charging-discharging data of a first battery cell pack at different first temperatures and different first rates, where the number of the first battery cell pack is at least one, and the first battery cell pack includes a first battery cell.

The acquiring module 601 is further configured to: acquire the different first temperatures according to a preset change parameter, and control a measuring space to reach the first temperatures, where the measuring space is used for placing the first battery cell pack;
if each first battery cell pack includes only one first battery cell, at each same first temperature, acquire charging-discharging data of each first battery cell pack at the different first rates;
if each first battery cell pack includes at least one first battery cell, at each same first temperature, acquire charging-discharging data of each first battery cell pack at the different first rates.

The acquiring module 601 is further configured to :
if each first battery cell pack comprises only one first battery cell,
at each same first temperature, acquire a first charging-discharging parameter of each first battery cell at a same first rate;
acquire the charging-discharging data of the first battery cell pack according to a first average value of the first charging-discharging parameter of at least one first battery cell at the same first rate and the first charging-discharging parameter;
if each first battery cell pack comprises at least one first battery cell,
at each same first temperature, acquire a second charging-discharging parameter of each first battery cell pack at the same first rate;
acquire the charging-discharging data of the first battery cell pack according to a second average value of the second charging-discharging parameter of at least one first battery cell pack at the same first rate and the second charging-discharging parameter.

The acquiring module 601 is further configured to: before controlling the measuring space to reach the first temperatures,
acquire a start time node where a humidity of the measuring space does not exceed a preset humidity;
acquire a standing time length of the measuring space according to the start time node and a current time node, where the standing time length is a time length when the humidity of the measuring space does not exceed the preset humidity continuously;
if the standing time length exceeds a preset time length, confirm to place the first battery cell pack in the measuring space.

The processing module 602 is configured to acquire first SOCs of the first battery cell pack according to the charging-discharging data, where the charging-discharging data includes first voltages of the first battery cell pack.

The associating module 603 is configured to establish an association table of the first SOCs with the first temperatures, the first rates and the first voltages.

The associating module 603 is further configured to: for each first battery cell pack, associate the first temperatures and the first rates for acquiring the charging-discharging data with the first voltages in the charging-discharging data to obtain a first association set;
associate the first voltages in the charging-discharging data for acquiring the first SOCs with the first SOCs to obtain a second association set;
acquire the association table according to the first association set and the second association set, where a model of the first battery cell is consistent with a model of the second battery cell.

The evaluating module 604 is configured to acquire a second temperature, a second rate and a second voltage of a battery pack, and acquire a second SOC of each second battery cell in the battery pack by the association table, where the battery pack includes multiple second battery cells.

The evaluating module 604 is further configured to: acquire a historical current and a historical temperature of the battery pack in a preset historical time period, and acquire the second voltage and the second rate according to the historical current;
acquire the second temperature of the battery pack according to the historical temperature.

The evaluating module 604 is further configured to:
acquire a current variation according to the preset historical time period and the historical current;
acquire a first coefficient according to the current variation and a first characteristic parameter of the battery pack;
acquire a second coefficient according to the preset historical time period, the first characteristic parameter and a second characteristic parameter of the battery pack;
acquire the second voltage according to the first coefficient and the second coefficient.

The present application further provides a battery SOC evaluation device, including: at least one processor and a memory;
where the memory stores computer-executable instructions;
the at least one processor executes the computer-executable instructions stored in the memory, so that the at least one processor executes the battery SOC evaluation method as described above.

FIG. 7 is a schematic diagram of hardware of a battery SOC evaluation device provided by an embodiment of the present application. As shown in FIG. 7, the battery SOC evaluation device 70 provided by this embodiment includes: at least one processor 701 and a memory 702. The device 70 further includes a communication component 703. The processor 701, the memory 702 and the communication component 703 are connected via a bus 704.

In a specific implementation process, the at least one processor 701 executes computer-executable instructions stored in the memory 702, so that the at least one processor executes the battery SOC evaluation method as described above.

The specific implementation process of the processor 701 can be found in the above method embodiments. Implementation principles and technical effects thereof are similar, and will not be repeated here in this embodiment.

In the above embodiment shown in FIG. 7, it should be understood that the processor may be a central processing unit (CPU), and may also be other general-purpose processors, digital signal processors (DSPs), application specific integrated circuits (ASICs), etc. A general-purpose processor may be a microprocessor or the processor may be any conventional processor, etc. The method steps disclosed in combination with the present application can be directly embodied as being executed and completed by a hardware processor, or by a combination of hardware and software modules in the processor.

The memory may include a high-speed memory (RAM) and may also include a non-volatile memory (NVM), such as at least one disk memory.

The bus may be an industry standard architecture (ISA) bus, a peripheral component interconnect (PCI) bus or an extended industry standard architecture (EISA) bus, etc. The bus can be divided into an address bus, a data bus, a control bus, etc. For the convenience of representation, the bus in the drawings of the present application is not limited to only one bus or one type of bus.

The present application further provides a computer-readable storage medium. The computer-readable storage medium stores computer-executable instructions, and when a processor executes the computer-executable instructions, the battery SOC evaluation method as described above is implemented.

The above computer-readable storage medium can be realized by any type of volatile or nonvolatile storage devices or their combinations, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk or an optical disk. The readable storage medium may be any available medium that can be accessed by a general-purpose or special-purpose computer.

An exemplary readable storage medium is coupled to a processor so that the processor can read information from the readable storage medium and write information to the readable storage medium. Of course, the readable storage medium may also be a constituent part of the processor. The processor and the readable storage medium may be located in an application specific integrated circuit (ASIC). Of course, the processor and the readable storage medium may also exist as separate components in the device.

The division of the units is only a logical functional division, and there may be other division manners in actual implementation. For example, multiple units or components may be combined or integrated into another system, or some features may be ignored or not implemented. In addition, a mutual coupling or a direct coupling or communication connection shown or discussed may be an indirect coupling or communication connection through some interfaces, apparatuses or units, and may be electrical, mechanical or in other forms.

The units described as separate components may or may not be physically separated, and the components displayed as units may or may not be physical units, that is, they may be located in one place or distributed to multiple network units. Some or all of the units may be selected according to actual needs to achieve a purpose of the solution of the embodiment.

It can be understood by those skilled in the art that all or part of steps for implementing the above method embodiments can be completed by hardware related to program instructions. The foregoing program may be stored in a computer-readable storage medium. When the program is executed, the steps including the above method embodiments are executed. The foregoing storage medium includes a ROM, a RAM, a magnetic disk, an optical disk or other media that can store program codes.

Finally, it should be noted that those skilled in the art will easily think of other embodiments of the present application after considering the description and practicing the application disclosed herein. The present application is intended to cover any variations, uses or adaptations of the present application. These variations, uses or adaptations follow general principles of the present application and include common knowledge or conventional technical means in the art that the present application has not disclosed, and are not limited to the precise structures described above and shown in the drawings. Various modifications and changes can be made without departing from the scope thereof. The scope of the present application is limited only by the appended claims.

## Claims

1. A battery state of charge, SOC, evaluation method, comprising:
acquiring (S201) charging-discharging data of a first battery cell pack at different first temperatures and different first rates, wherein the number of the first battery cell pack is at least one, and the first battery cell pack comprises a first battery cell;
acquiring (S202) first SOCs of the first battery cell pack according to the charging-discharging data, wherein the charging-discharging data comprises first voltages of the first battery cell pack;
establishing (S203) an association table of the first SOCs with the first temperatures, the first rates and the first voltages, wherein the association table comprises a correspondence between the first SOCs and the first temperatures, the first rates and the first voltages, and the first battery cell pack is taken as an experimental object when establishing the association table;
acquiring (S204) a second temperature, a second rate and a second voltage of a battery pack, and acquiring (S204) a second SOC of each second battery cell in the battery pack using the association table, wherein the battery pack comprises multiple second battery cells;
wherein the acquiring (S204) the second SOC of each second battery cell in the battery pack using the association table comprises:
mapping the second temperature, the second rate and the second voltage to the association table to find the second SOC of each second battery cell in the battery pack.

2. The method according to claim 1, wherein acquiring (S201) the charging-discharging data of the first battery cell pack at different first temperatures and different first rates comprises:
acquiring (S301) the different first temperatures according to a preset change parameter, and controlling a measuring space to reach the first temperatures, wherein the measuring space is used for placing the first battery cell pack;
if each first battery cell pack comprises only one first battery cell, at each same first temperature, acquiring (S302) charging-discharging data of each first battery cell pack at the different first rates;
if each first battery cell pack comprises at least one first battery cell, at each same first temperature, acquiring (S303) charging-discharging data of each first battery cell pack at the different first rates.

3. The method according to claim 2, wherein if each first battery cell pack comprises only one first battery cell, the method further comprises:
at each same first temperature, acquiring a first charging-discharging parameter of each first battery cell at a same first rate;
acquiring the charging-discharging data of the first battery cell pack according to a first average value of the first charging-discharging parameter of at least one first battery cell at the same first rate and the first charging-discharging parameter;
if each first battery cell pack comprises at least one first battery cell, the method further comprises:
at each same first temperature, acquiring a second charging-discharging parameter of each first battery cell pack at the same first rate;
acquiring the charging-discharging data of the first battery cell pack according to a second average value of the second charging-discharging parameter of at least one first battery cell pack at the same first rate and the second charging-discharging parameter.

4. The method according to claim 1, wherein establishing (S203) the association table of the first SOCs with the first temperatures, the first rates and the first voltages comprises:
for each first battery cell pack, associating (S401) the first temperatures and the first rates for acquiring the charging-discharging data with the first voltages in the charging-discharging data to obtain a first association set;
associating (S402) the first voltages in the charging-discharging data for acquiring the first SOCs with the first SOCs to obtain a second association set;
acquiring (S403) the association table according to the first association set and the second association set, wherein a model of the first battery cell is consistent with a model of the second battery cell.

5. The method according to claim 1, wherein acquiring (S204) the second temperature, the second rate and the second voltage of the battery pack comprises:
acquiring (S501) a historical current and a historical temperature of the battery pack in a preset historical time period, and acquiring the second voltage and the second rate according to the historical current;
acquiring (S502) the second temperature of the battery pack according to the historical temperature.

6. The method according to claim 5, wherein acquiring the second voltage according to the historical current comprises:
acquiring a current variation according to the preset historical time period and the historical current;
acquiring a first coefficient according to the current variation and a first characteristic parameter of the battery pack;
acquiring a second coefficient according to the preset historical time period, the first characteristic parameter and a second characteristic parameter of the battery pack;
acquiring the second voltage according to the first coefficient and the second coefficient.

7. The method according to claim 2, wherein before controlling the measuring space to reach the first temperatures, the method further comprises:
acquiring a start time node where a humidity of the measuring space does not exceed a preset humidity;
acquiring a standing time length of the measuring space according to the start time node and a current time node, wherein the standing time length is a time length when the humidity of the measuring space does not exceed the preset humidity continuously;
if the standing time length exceeds a preset time length, confirming to place the first battery cell pack in the measuring space.

8. A battery state of charge, SOC, evaluation apparatus, comprising:
an acquiring module (601), configured to acquire charging-discharging data of a first battery cell pack at different first temperatures and different first rates, wherein the number of the first battery cell pack is at least one, and the first battery cell pack comprises a first battery cell;
a processing module (602), configured to acquire first SOCs of the first battery cell pack according to the charging-discharging data, wherein the charging-discharging data comprises first voltages of the first battery cell pack;
an associating module (603), configured to establish an association table of the first SOCs with the first temperatures, the first rates and the first voltages, wherein the association table comprises a correspondence between the first SOCs and the first temperatures, the first rates and the first voltages, and the first battery cell pack is taken as an experimental object when establishing the association table;
an evaluating module (604), configured to acquire a second temperature, a second rate and a second voltage of a battery pack, and acquire a second SOC of each second battery cell in the battery pack using the association table, wherein the battery pack comprises multiple second battery cells;
wherein the evaluating module (604) is specifically configured to:
map the second temperature, the second rate and the second voltage to the association table to find the second SOC of each second battery cell in the battery pack.

9. The apparatus according to claim 8, wherein the acquiring module (601) is specifically configured to:
acquire the different first temperatures according to a preset change parameter, and control a measuring space to reach the first temperatures, wherein the measuring space is used for placing the first battery cell pack;
if each first battery cell pack comprises only one first battery cell, at each same first temperature, acquire charging-discharging data of each first battery cell pack at the different first rates;
if each first battery cell pack comprises at least one first battery cell, at each same first temperature, acquire charging-discharging data of each first battery cell pack at the different first rates.

10. The apparatus according to claim 9, wherein the acquiring module (601) is further configured to:
if each first battery cell pack comprises only one first battery cell,
at each same first temperature, acquire a first charging-discharging parameter of each first battery cell at a same first rate;
acquire the charging-discharging data of the first battery cell pack according to a first average value of the first charging-discharging parameter of at least one first battery cell at the same first rate and the first charging-discharging parameter;
if each first battery cell pack comprises at least one first battery cell,
at each same first temperature, acquire a second charging-discharging parameter of each first battery cell pack at the same first rate;
acquire the charging-discharging data of the first battery cell pack according to a second average value of the second charging-discharging parameter of at least one first battery cell pack at the same first rate and the second charging-discharging parameter.

11. The apparatus according to claim 8, wherein the associating module (603) is specifically configured to:
for each first battery cell pack, associate the first temperatures and the first rates for acquiring the charging-discharging data with the first voltages in the charging-discharging data to obtain a first association set;
associate the first voltages in the charging-discharging data for acquiring the first SOCs with the first SOCs to obtain a second association set;
acquire the association table according to the first association set and the second association set, wherein a model of the first battery cell is consistent with a model of the second battery cell.

12. The apparatus according to claim 8, wherein the evaluating module (604) is specifically configured to:
acquire a historical current and a historical temperature of the battery pack in a preset historical time period, and acquire the second voltage and the second rate according to the historical current;
acquire the second temperature of the battery pack according to the historical temperature.

13. The apparatus according to claim 12, wherein the evaluating module (604) is specifically configured to:
acquire a current variation according to the preset historical time period and the historical current;
acquire a first coefficient according to the current variation and a first characteristic parameter of the battery pack;
acquire a second coefficient according to the preset historical time period, the first characteristic parameter and a second characteristic parameter of the battery pack;
acquire the second voltage according to the first coefficient and the second coefficient.

14. A battery state of charge, SOC, evaluation device (70), comprising: at least one processor (701) and a memory (702);
wherein the memory (702) stores computer-executable instructions;
the at least one processor (701) executes the computer-executable instructions stored in the memory (702), so that the at least one processor (701) executes the battery SOC evaluation method according to any one of claims 1-7.

15. A computer-readable storage medium, having a computer program stored thereon, wherein steps of the battery SOC evaluation method according to any one of claims 1-7 are implemented when the computer program is executed by a processor.

## Patentansprüche

1. . Bewertungsverfahren für den Ladezustand, SOC, einer Batterie, umfassend:
Erfassen (S201) von Lade-Entladedaten eines ersten Batteriezellenpacks bei unterschiedlichen ersten Temperaturen und unterschiedlichen ersten Raten, wobei die Anzahl des ersten Batteriezellenpacks mindestens eins beträgt und das erste Batteriezellenpack eine erste Batteriezelle umfasst;
Erfassen (S202) erster SOCs des ersten Batteriezellenpacks gemäß den Lade-Entladedaten, wobei die Lade-Entladedaten erste Spannungen des ersten Batteriezellenpacks umfassen;
Erstellen (S203) einer Zuordnungstabelle der ersten SOCs mit den ersten Temperaturen, den ersten Raten und den ersten Spannungen, wobei die Zuordnungstabelle eine Übereinstimmung zwischen den ersten SOCs und den ersten Temperaturen, den ersten Raten und den ersten Spannungen umfasst, und das erste Batteriezellenpack als Versuchsobjekt bei dem Erstellen der Zuordnungstabelle hergenommen wird;
Erfassen (S204) einer zweiten Temperatur, einer zweiten Rate und einer zweiten Spannung eines Batteriepacks und Erfassen (S204) eines zweiten SOC jeder zweiten Batteriezelle in dem Batteriepack unter Verwendung der Zuordnungstabelle, wobei das Batteriepack mehrere zweite Batteriezellen umfasst;
wobei das Erfassen (S204) des zweiten SOC jeder zweiten Batteriezelle in dem Batteriepack unter Verwendung der Zuordnungstabelle Folgendes umfasst:
Abbilden der zweiten Temperatur, der zweiten Rate und der zweiten Spannung in der Zuordnungstabelle, um den zweiten SOC jeder zweiten Batteriezelle in dem Batteriepack zu ermitteln.

2. . Verfahren nach Anspruch 1, wobei das Erfassen (S201) der Lade-Entladedaten des ersten Batteriezellenpacks bei unterschiedlichen ersten Temperaturen und unterschiedlichen ersten Raten Folgendes umfasst:
Erfassen (S301) der unterschiedlichen ersten Temperaturen gemäß einem voreingestellten Änderungsparameter und Steuern eines Messraums zum Erreichen der ersten Temperaturen, wobei der Messraum zum Platzieren des ersten Batteriezellenpacks verwendet wird;
wenn jedes erste Batteriezellenpack nur eine erste Batteriezelle umfasst, bei jeweils derselben ersten Temperatur, Erfassen (S302) von Lade-Entladedaten jedes ersten Batteriezellenpacks mit den unterschiedlichen ersten Raten;
wenn jedes erste Batteriezellenpack mindestens eine erste Batteriezelle umfasst, bei jeweils derselben ersten Temperatur, Erfassen (S303) von Lade-Entladedaten jedes ersten Batteriezellenpacks mit den unterschiedlichen ersten Raten.

3. . Verfahren nach Anspruch 2, wobei, wenn jedes erste Batteriezellenpack nur eine erste Batteriezelle umfasst, das Verfahren ferner Folgendes umfasst:
bei jeweils derselben ersten Temperatur, Erfassen eines ersten Lade-Entladeparameters jeder ersten Batteriezelle mit derselben ersten Rate;
Erfassen der Lade-Entladedaten des ersten Batteriezellenpacks gemäß einem ersten Durchschnittswert des ersten Lade-Entladeparameters von mindestens einer ersten Batteriezelle mit derselben ersten Rate und dem ersten Lade-Entladeparameter;
wenn jedes erste Batteriezellenpack mindestens eine erste Batteriezelle umfasst, umfasst das Verfahren ferner Folgendes:
bei jeweils derselben ersten Temperatur, Erfassen eines zweiten Lade-/Entladeparameters jedes ersten Batteriezellenpacks mit derselben ersten Rate;
Erfassen der Lade-Entladedaten des ersten Batteriezellenpacks gemäß einem zweiten Durchschnittswert des zweiten Lade-Entladeparameters von mindestens einem ersten Batteriezellenpack mit derselben ersten Rate und dem zweiten Lade-Entladeparameter.

4. . Verfahren nach Anspruch 1, wobei das Erstellen (S203) der Zuordnungstabelle der ersten SOCs mit den ersten Temperaturen, den ersten Raten und den ersten Spannungen Folgendes umfasst:
für jedes erste Batteriezellenpack, Zuordnen (S401) der ersten Temperaturen und der ersten Raten zum Erfassen der Lade-Entladedaten zu den ersten Spannungen in den Lade-Entladedaten, um einen ersten Zuordnungssatz zu erhalten;
Zuordnen (S402) der ersten Spannungen in den Lade-Entladedaten zum Erfassen der ersten SOCs zu den ersten SOCs, um einen zweiten Zuordnungssatz zu erhalten;
Erfassen (S403) der Zuordnungstabelle gemäß dem ersten Zuordnungssatz und dem zweiten Zuordnungssatz, wobei ein Modell der ersten Batteriezelle mit einem Modell der zweiten Batteriezelle übereinstimmt.

5. . Verfahren nach Anspruch 1, wobei das Erfassen (S204) der zweiten Temperatur, der zweiten Rate und der zweiten Spannung des Batteriepacks Folgendes umfasst:
Erfassen (S501) eines historischen Stroms und einer historischen Temperatur des Batteriepacks in einem voreingestellten historischen Zeitraum und Erfassen der zweiten Spannung und der zweiten Rate gemäß dem historischen Strom;
Erfassen (S502) der zweiten Temperatur des Batteriepacks gemäß der historischen Temperatur.

6. . Verfahren nach Anspruch 5, wobei das Erfassen der zweiten Spannung gemäß dem historischen Strom Folgendes umfasst:
Erfassen einer Stromvariation gemäß dem voreingestellten historischen Zeitraum und dem historischen Strom;
Erfassen eines ersten Koeffizienten gemäß der Stromvariation und eines ersten Merkmalsparameters des Batteriepacks;
Erfassen eines zweiten Koeffizienten gemäß dem voreingestellten historischen Zeitraum, dem ersten Merkmalsparameter und einem zweiten Merkmalsparameter des Batteriepacks;
Erfassen der zweiten Spannung gemäß dem ersten Koeffizienten und dem zweiten Koeffizienten.

7. . Verfahren nach Anspruch 2, wobei das Verfahren vor dem Steuern des Messraums zum Erreichen der ersten Temperaturen ferner Folgendes umfasst:
Erfassen eines Startzeitknotens, bei dem eine Luftfeuchtigkeit des Messraums eine voreingestellte Luftfeuchtigkeit nicht überschreitet;
Erfassen einer Standzeitdauer des Messraums gemäß dem Startzeitknoten und einem aktuellen Zeitknoten, wobei die Standzeitdauer eine Zeitdauer ist, wenn die Luftfeuchtigkeit des Messraums die voreingestellte Luftfeuchtigkeit nicht kontinuierlich überschreitet;
wenn die Standzeitdauer eine voreingestellte Zeitdauer überschreitet, Bestätigen, dass das erste Batteriezellenpack in den Messraum eingelegt werden soll.

8. . Bewertungsvorrichtung für den Ladezustand, SOC, einer Batterie, umfassend:
ein Erfassungsmodul (601), das so konfiguriert ist, dass es Lade-Entladedaten eines ersten Batteriezellenpacks bei unterschiedlichen ersten Temperaturen und unterschiedlichen ersten Raten erfasst, wobei die Anzahl des ersten Batteriezellenpacks mindestens eins beträgt und das erste Batteriezellenpack eine erste Batteriezelle umfasst;
ein Verarbeitungsmodul (602), das so konfiguriert ist, dass es erste SOCs des ersten Batteriezellenpacks gemäß den Lade-Entladedaten erfasst, wobei die Lade-Entladedaten erste Spannungen des ersten Batteriezellenpacks umfassen;
ein Zuordnungsmodul (603), das so konfiguriert ist, dass es eine Zuordnungstabelle der ersten SOCs mit den ersten Temperaturen, den ersten Raten und den ersten Spannungen erstellt, wobei die Zuordnungstabelle eine Übereinstimmung zwischen den ersten SOCs und den ersten Temperaturen, den ersten Raten und den ersten Spannungen umfasst, und das erste Batteriezellenpack als Versuchsobjekt bei dem Erstellen der Zuordnungstabelle hergenommen wird;
ein Bewertungsmodul (604), das so konfiguriert ist, dass es eine zweite Temperatur, eine zweite Rate und eine zweite Spannung eines Batteriepacks erfasst und einen zweiten SOC jeder zweiten Batteriezelle in dem Batteriepack unter Verwendung der Zuordnungstabelle erfasst, wobei das Batteriepack mehrere zweite Batteriezellen umfasst;
wobei das Bewertungsmodul (604) speziell für Folgendes konfiguriert ist:
Abbilden der zweiten Temperatur, der zweiten Rate und der zweiten Spannung in der Zuordnungstabelle, um den zweiten SOC jeder zweiten Batteriezelle in dem Batteriepack zu ermitteln.

9. . Vorrichtung nach Anspruch 8, wobei das Erfassungsmodul (601) speziell für Folgendes konfiguriert ist:
Erfassen der unterschiedlichen ersten Temperaturen gemäß einem voreingestellten Änderungsparameter und Steuern eines Messraums zum Erreichen der ersten Temperaturen, wobei der Messraum zum Platzieren des ersten Batteriezellenpacks verwendet wird;
wenn jedes erste Batteriezellenpack nur eine erste Batteriezelle umfasst, bei jeweils derselben ersten Temperatur, Erfassen von Lade-Entladedaten jedes ersten Batteriezellenpacks mit den unterschiedlichen ersten Raten;
wenn jedes erste Batteriezellenpack mindestens eine erste Batteriezelle umfasst, bei jeweils derselben ersten Temperatur, Erfassen von Lade-Entladedaten jedes ersten Batteriezellenpacks mit den unterschiedlichen ersten Raten.

10. . Vorrichtung nach Anspruch 9, wobei das Erfassungsmodul (601) ferner für Folgendes konfiguriert ist:
wenn jedes erste Batteriezellenpack nur eine erste Batteriezelle umfasst,
bei jeweils derselben ersten Temperatur, Erfassen eines ersten Lade-Entladeparameters jeder ersten Batteriezelle mit derselben ersten Rate;
Erfassen der Lade-Entladedaten des ersten Batteriezellenpacks gemäß einem ersten Durchschnittswert des ersten Lade-Entladeparameters von mindestens einer ersten Batteriezelle mit derselben ersten Rate und dem ersten Lade-Entladeparameter;
wenn jedes erste Batteriezellenpack mindestens eine erste Batteriezelle umfasst,
bei jeweils derselben ersten Temperatur, Erfassen eines zweiten Lade-/Entladeparameters jedes ersten Batteriezellenpacks mit derselben ersten Rate;
Erfassen der Lade-Entladedaten des ersten Batteriezellenpacks gemäß einem zweiten Durchschnittswert des zweiten Lade-Entladeparameters von mindestens einem ersten Batteriezellenpack mit derselben ersten Rate und dem zweiten Lade-Entladeparameter.

11. . Vorrichtung nach Anspruch 8, wobei das Zuordnungsmodul (603) speziell für Folgendes konfiguriert ist:
für jedes erste Batteriezellenpack, Zuordnen der ersten Temperaturen und der ersten Raten zum Erfassen der Lade-Entladedaten zu den ersten Spannungen in den Lade-Entladedaten, um einen ersten Zuordnungssatz zu erhalten;
Zuordnen der ersten Spannungen in den Lade-Entladedaten zum Erfassen der ersten SOCs zu den ersten SOCs, um einen zweiten Zuordnungssatz zu erhalten;
Erfassen der Zuordnungstabelle gemäß dem ersten Zuordnungssatz und dem zweiten Zuordnungssatz, wobei ein Modell der ersten Batteriezelle mit einem Modell der zweiten Batteriezelle übereinstimmt.

12. . Vorrichtung nach Anspruch 8, wobei das Bewertungsmodul (604) speziell für Folgendes konfiguriert ist:
Erfassen eines historischen Stroms und einer historischen Temperatur des Batteriepacks in einem voreingestellten historischen Zeitraum und Erfassen der zweiten Spannung und der zweiten Rate gemäß dem historischen Strom;
Erfassen der zweiten Temperatur des Batteriepacks gemäß der historischen Temperatur.

13. . Vorrichtung nach Anspruch 12, wobei das Bewertungsmodul (604) speziell für Folgendes konfiguriert ist:
Erfassen einer Stromvariation gemäß dem voreingestellten historischen Zeitraum und dem historischen Strom;
Erfassen eines ersten Koeffizienten gemäß der Stromvariation und eines ersten Merkmalsparameters des Batteriepacks;
Erfassen eines zweiten Koeffizienten gemäß dem voreingestellten historischen Zeitraum, dem ersten Merkmalsparameter und einem zweiten Merkmalsparameter des Batteriepacks;
Erfassen der zweiten Spannung gemäß dem ersten Koeffizienten und dem zweiten Koeffizienten.

14. . Bewertungsvorrichtung (70) für den Ladezustand, SOC, einer Batterie, umfassend: mindestens einen Prozessor (701) und einen Speicher (702);
wobei der Speicher (702) computerausführbare Anweisungen speichert und
der mindestens eine Prozessor (701) die in dem Speicher (702) gespeicherten computerausführbaren Anweisungen ausführt, sodass der mindestens eine Prozessor (701) das Bewertungsverfahren für den Ladezustand, SOC, einer Batterie nach einem der Ansprüche 1 bis 7 ausführt.

15. . Computerlesbares Speichermedium, auf dem ein Computerprogramm gespeichert ist, wobei Schritte des Bewertungsverfahrens für den Ladezustand, SOC, einer Batterie nach einem der Ansprüche 1 bis 7 implementiert werden, wenn das Computerprogramm von einem Prozessor ausgeführt wird.

## Revendications

1. Procédé d'évaluation de l'état de charge, SOC, de batterie, comportant :
l'acquisition (S201) de données de charge-décharge d'un premier bloc de cellules de batterie à différentes premières températures et différents premiers régimes, dans lequel le nombre du premier bloc de cellules de batterie est au moins un, et le premier bloc de cellules de batterie comporte une première cellule de batterie ;
l'acquisition (S202) de premiers SOC du premier bloc de cellules de batterie en fonction des données de charge-décharge, dans lequel les données de charge-décharge comportent les premières tensions du premier bloc de cellules de batterie ;
l'établissement (S203) d'une table d'association des premiers SOC avec les premières températures, les premiers régimes et les premières tensions, dans lequel la table d'association comporte une correspondance entre les premiers SOC et les premières températures, les premiers régimes et les premières tensions, et le premier bloc de cellules de batterie est pris comme objet expérimental lors de l'établissement de la table d'association ;
l'acquisition (S204) d'une deuxième température, d'un deuxième régime et d'une deuxième tension d'un bloc-batterie, et l'acquisition (S204) d'un deuxième SOC de chaque deuxième cellule de batterie dans le bloc-batterie à l'aide de la table d'association, dans lequel le bloc-batterie comporte plusieurs deuxièmes cellules de batterie ;
dans lequel l'acquisition (S204) du deuxième SOC de chaque deuxième cellule de batterie dans le bloc-batterie à l'aide de la table d'association comporte :
la mise en correspondance de la deuxième température, du deuxième régime et de la deuxième tension avec la table d'association pour trouver le deuxième SOC de chaque deuxième cellule de batterie dans le bloc-batterie.

2. Procédé selon la revendication 1, dans lequel l'acquisition (S201) des données de charge-décharge du premier bloc de cellules de batterie à différentes premières températures et différents premiers régimes comporte :
l'acquisition (S301) des différentes premières températures en fonction d'un paramètre de changement prédéfini, et la commande d'un espace de mesure pour atteindre les premières températures, dans lequel l'espace de mesure est utilisé pour placer le premier bloc de cellules de batterie ;
si chaque premier bloc de cellules de batterie ne comporte qu'une seule première cellule de batterie, à chaque même première température, l'acquisition (S302) de données de charge-décharge de chaque premier bloc de cellules de batterie aux différents premiers régime ;
si chaque premier bloc de cellules de batterie comporte au moins une première cellule de batterie, à chaque même première température, l'acquisition (S303) de données de charge-décharge de chaque premier bloc de cellules de batterie aux différents premiers régimes.

3. Procédé selon la revendication 2, dans lequel si chaque premier bloc de cellules de batterie ne comporte qu'une seule première cellule de batterie, le procédé comporte en outre :
à chaque même première température, l'acquisition d'un premier paramètre de charge-décharge de chaque première cellule de batterie à un même premier régime ;
l'acquisition des données de charge-décharge du premier bloc de cellules de batterie en fonction d'une première valeur moyenne du premier paramètre de charge-décharge d'au moins une première cellule de batterie au même premier régime et du premier paramètre de charge-décharge ;
si chaque premier bloc de cellules de batterie comporte au moins une première cellule de batterie, le procédé comporte en outre :
à chaque même première température, l'acquisition d'un deuxième paramètre de charge-décharge de chaque premier bloc de cellules de batterie au même premier régime ;
l'acquisition des données de charge-décharge du premier bloc de cellules de batterie en fonction d'une deuxième valeur moyenne du deuxième paramètre de charge-décharge d'au moins un premier bloc de cellules de batterie au même premier régime et du deuxième paramètre de charge-décharge.

4. Procédé selon la revendication 1, dans lequel l'établissement (S203) de la table d'association des premiers SOC avec les premières températures, les premiers régimes et les premières tensions comporte :
pour chaque premier bloc de cellules de batterie, l'association (S401) des premières températures et des premiers régimes d'acquisition des données de charge-décharge avec les premières tensions dans les données de charge-décharge pour obtenir un premier ensemble d'association ;
l'association (S402) des premières tensions dans les données de charge-décharge d'acquisition des premiers SOC avec les premiers SOC pour obtenir un deuxième ensemble d'association ;
l'acquisition (S403) de la table d'association en fonction du premier ensemble d'association et du deuxième ensemble d'association, dans lequel un modèle de la première cellule de batterie est cohérent avec un modèle de la deuxième cellule de batterie.

5. Procédé selon la revendication 1, dans lequel l'acquisition (S204) de la deuxième température, du deuxième régime et de la deuxième tension du bloc-batterie comporte :
l'acquisition (S501) d'un courant historique et d'une température historique du bloc-batterie dans une période de temps historique prédéfinie, et l'acquisition de la deuxième tension et du deuxième régime en fonction du courant historique ;
l'acquisition (S502) de la deuxième température du bloc-batterie en fonction de la température historique.

6. Procédé selon la revendication 5, dans lequel l'acquisition de la deuxième tension en fonction du courant historique comporte :
l'acquisition d'une variation de courant en fonction de la période de temps historique prédéfinie et du courant historique ;
l'acquisition d'un premier coefficient en fonction de la variation de courant et d'un premier paramètre caractéristique du bloc-batterie ;
l'acquisition d'un deuxième coefficient en fonction de la période de temps historique prédéfinie, du premier paramètre caractéristique et d'un deuxième paramètre caractéristique du bloc-batterie ;
l'acquisition de la deuxième tension en fonction du premier coefficient et le deuxième coefficient.

7. Procédé selon la revendication 2, dans lequel avant de commander l'espace de mesure pour atteindre les premières températures, le procédé comporte en outre :
l'acquisition d'un nœud d'heure de début où une humidité de l'espace de mesure ne dépasse pas une humidité prédéfinie ;
l'acquisition d'une durée de repos de l'espace de mesure en fonction du nœud de temps de démarrage et d'un nœud de temps actuel, dans lequel la durée de repos est une durée lorsque l'humidité de l'espace de mesure ne dépasse pas l'humidité prédéfinie en continu ;
si la durée de repos dépasse une durée prédéfinie, la confirmation de placement du premier bloc de cellules de batterie dans l'espace de mesure.

8. Appareil d'évaluation d'état de charge, SOC, de batterie comportant :
un module d'acquisition (601), configuré pour acquérir des données de charge-décharge d'un premier bloc de cellules de batterie à différentes premières températures et différents premiers régimes, dans lequel le nombre du premier bloc de cellules de batterie est au moins un, et le premier bloc de cellules de batterie comporte une première cellule de batterie ;
un module de traitement (602), configuré pour acquérir des premiers SOC du premier bloc de cellules de batterie en fonction des données de charge-décharge, dans lequel les données de charge-décharge comportent les premières tensions du premier bloc de cellules de batterie ;
un module d'association (603), configuré pour établir une table d'association des premiers SOC avec les premières températures, les premiers régimes et les premières tensions, dans lequel la table d'association comporte une correspondance entre les premiers SOC et les premières températures, les premiers régimes et les premières tensions, et le premier bloc de cellules de batterie est pris comme objet expérimental lors de l'établissement de la table d'association ;
un module d'évaluation (604), configuré pour acquérir une deuxième température, un deuxième régime et une deuxième tension d'un bloc-batterie, et acquérir un deuxième SOC de chaque deuxième cellule de batterie dans le bloc-batterie à l'aide de la table d'association, dans lequel le bloc-batterie comporte plusieurs deuxièmes cellules de batterie ;
dans lequel le module d'évaluation (604) est spécifiquement configuré pour :
mettre en correspondance la deuxième température, le deuxième régime et la deuxième tension avec la table d'association pour trouver le deuxième SOC de chaque deuxième cellule de batterie dans le bloc-batterie.

9. Appareil selon la revendication 8, dans lequel le module d'acquisition (601) est spécifiquement configuré pour :
acquérir les différentes premières températures en fonction d'un paramètre de changement prédéfini, et commander un espace de mesure pour atteindre les premières températures, dans lequel l'espace de mesure est utilisé pour placer le premier bloc de cellules de batterie ;
si chaque premier bloc de cellules de batterie ne comporte qu'une seule première cellule de batterie, à chaque même première température, acquérir des données de charge-décharge de chaque premier bloc de cellules de batterie aux différents premiers régime ;
si chaque premier bloc de cellules de batterie comporte au moins une première cellule de batterie, à chaque même première température, acquérir des données de charge-décharge de chaque premier bloc de cellules de batterie aux différents premiers régimes.

10. Appareil selon la revendication 9, dans lequel le module d'acquisition (601) est en outre configuré pour :
si chaque premier bloc de cellules de batterie ne comporte qu'une première cellule de batterie,
à chaque même première température, acquérir un premier paramètre de charge-décharge de chaque première cellule de batterie à un même premier régime ;
acquérir les données de charge-décharge du premier bloc de cellules de batterie en fonction d'une première valeur moyenne du premier paramètre de charge-décharge d'au moins une première cellule de batterie au même premier régime et du premier paramètre de charge-décharge ;
si chaque premier bloc de cellules de batterie comporte au moins une première cellule de batterie,
à chaque même première température, acquérir un deuxième paramètre de charge-décharge de chaque premier bloc de cellules de batterie au même premier régime ;
acquérir les données de charge-décharge du premier bloc de cellules de batterie en fonction d'une deuxième valeur moyenne du deuxième paramètre de charge-décharge d'au moins un premier bloc de cellules de batterie au même premier régime et le deuxième paramètre de charge-décharge.

11. Appareil selon la revendication 8, dans lequel le module d'association (603) est spécifiquement configuré pour :
pour chaque premier bloc de cellules de batterie, associer les premières températures et les premiers régimes d'acquisition des données de charge-décharge aux premières tensions dans les données de charge-décharge pour obtenir un premier ensemble d'association ;
associer les premières tensions dans les données de charge-décharge d'acquisition des premiers SOC avec les premiers SOC pour obtenir un deuxième ensemble d'association ;
acquérir la table d'association en fonction du premier ensemble d'association et du deuxième ensemble d'association, dans lequel un modèle de la première cellule de batterie est cohérent avec un modèle de la deuxième cellule de batterie.

12. Appareil selon la revendication 8, dans lequel le module d'évaluation (604) est spécifiquement configuré pour :
acquérir un courant historique et une température historique du bloc-batterie dans une période de temps historique prédéfinie, et acquérir la deuxième tension et le deuxième régime en fonction du courant historique ;
acquérir la deuxième température du bloc-batterie en fonction de la température historique.

13. Appareil selon la revendication 12, dans lequel le module d'évaluation (604) est spécifiquement configuré pour :
acquérir une variation de courant en fonction de la période de temps historique prédéfinie et du courant historique ;
acquérir un premier coefficient en fonction de la variation de courant et un premier paramètre caractéristique du bloc-batterie ;
acquérir un deuxième coefficient en fonction de la période de temps historique prédéfinie, du premier paramètre caractéristique et d'un deuxième paramètre caractéristique du bloc-batterie ;
acquérir la deuxième tension en fonction du premier coefficient et du deuxième coefficient.

14. Dispositif d'évaluation (70) de l'état de charge, SOC, de batterie, comportant : au moins un processeur (701) et une mémoire (702) ;
dans lequel la mémoire (702) stocke des instructions exécutables par ordinateur ;
l'au moins un processeur (701) exécute les instructions exécutables par ordinateur stockées dans la mémoire (702), de sorte que l'au moins un processeur (701) exécute le procédé d'évaluation du SOC de la batterie selon l'une quelconque des revendications 1 à 7.

15. Support de stockage lisible par ordinateur, ayant un programme informatique stocké sur celui-ci, dans lequel des étapes du procédé d'évaluation du SOC de la batterie selon l'une quelconque des revendications 1 à 7 sont mises en œuvre lorsque le programme informatique est exécuté par un processeur.
